# EUROPEAN PATENT SPECIFICATION

(11) **EP 0 380 326 B1**
(45) Date of publication and mention of the grant of the patent: **21.12.1994**
(21) Application number: 90300752.4
(22) Date of filing: 24.01.1990
(51) Int. Cl.: C23C 14/08, C23C 14/06, H01L 29/95, H01L 21/3205, H01L 21/3105, H01G 7/06

(54) **Method of manufacturing a semi-conductor device**
Verfahren zur Herstellung einer Halbleitervorrichtung
Procédé de fabrication d'un dispositif à semi-conducteur

(30) Priority: 26.01.1989 JP 17218/89; 27.01.1989 JP 18710/89; 27.01.1989 JP 18711/89; 08.02.1989 JP 28942/89
(43) Date of publication of application: 01.08.1990
(73) Proprietor: SEIKO EPSON CORPORATION, Shinjuku-ku Tokyo (JP)
(72) Inventor: Takenaka, Kazuhiro, Suwa-shi, Nagano-ken (JP)
(74) Representative: Sturt, Clifford Mark

(56) References cited:
- US-A- 4 437 139
- JAPANESE JOURNAL OF APPLIED PHYSICS, vol. 17, no. 3, March, 1978, TOKYO, JP, pages 573-574; SHINTANI ET AL.: "Pb(Zr.Ti)O3 films by RF sputtering in PbO vapour"
- PATENT ABSTRACTS OF JAPAN, vol. 013, no. 169 (C-587), 21April 1989; & JP-A-63 317 670
- PATENT ABSTRACTS OF JAPAN, vol. 012, no. 275 (C-516), 29 July 1988; & JP-A-63 053 264
- JAPANESE JOURNAL OF APPLIED PHYSICS, vol. 18, no. 8, August 1977, TOKYO, JP, pages 1633-1634; OKUYAMA ET AL.: "Preparation of PbTiO3 ferroelectric thin film by RF sputtering"
- JOURNAL OF VACUUM SCIENCE AND TECHNOLOGY, vol. 17, no. 2, March 1980, NEW YORK, US, pages 629-633; CASTELLANO: "Ion beam deposition of ferroelectric thin films sputtered from multicomponent targets"

## Description

This invention relates to methods of manufacturing semi-conductor devices, in particular, those including a ferro-electric thin film, for example for use in memory devices.

In the prior art, MIS type transistors, which employ the change of surface potential on a silicon substrate caused by introducing electric charge from the substrate to a trap or floating gate within an isolation gate, are used as non-volatile memory. In practice, such non-volatile memory may be used in Erasable and Programmable Read Only Memory (EPROM) and Electrically Erasable Programmable Read Only Memory (EEPROM).

Such non-volatile memory has problems, in that the read/write voltage is usually high, about 20 V, read/write takes a relatively long time, several tens of milli-seconds in the case of EEPROM, and read/write capability is low, being in the order of 10⁵ repetitions.

Because the read/write time is theoretically the same in non-volatile memory employing a ferro-electric material which is electrically capable of polarity turn-about, and polarisation is kept, even when the source of electricity is shut off, non-volatile memory employing a ferro-electric film has the potential of being an ideal non-volatile memory. Non-volatile memory employing ferro-electric material has been suggested in, for example, US-A-4,149,302 as an integrated construction of ferro-electric capacitors on a silicon substrate, and US-A-3,832,700 as a non-volatile memory having ferro-electric films laid at the gate of MIS type transistor. In practice, however, non-volatile memory employing a ferro-electric material is not of use because ferro-electric thin films are not stable enough and ferro-electric films of stoichiometric composition are hard to be realised. In the case when, for example, PZT (PbTiO₃/PbZrO₃) is to be employed as a ferro-electric film, and, for example, sputtering is used for its construction, then the result is an oxide of three elements, and the ratio of Pb, Ti and Zr in the sputtered film does not match the stoichiometric composition. A common method of trying to cope with this problem, is to add more PbO to the sputtering target, but even in this case, the ratio goes off the stoichiometric composition. Oxygen may be used as a sputtering gas, but a lack of oxygen in the sputtered film occurs.

Japanese Journal of Applied Physics, Vol. 17, No. 3, March 1978, Tokyo JP, pages 573-574, discloses a method of forming ferro-magnetic films by sputtering but does not suggest ion implantation to improve the stoichiometric composition of the film. Similar disclosures are to be found in the Patent Abstracts of Japan, Vol. 13, No. 169 (C-587) and JP-A-63-317670, and in the Japanese Journal of Applied Physics, Vol. 18, No. 8, August 1977, Tokyo JP, pages 1633-1634.

In the Patent Abstracts of Japan, Vol. 12, No. 275 (C-516), and JP-A-63-053264, is disclosed the formation of a thin ferro-magnetic film by sputtering and thereafter projecting O₂ ion beams onto the surface of the film to react on the surface with other elements.

According to the invention, therefore, a method of manufacturing a semiconductor device, comprises the steps of forming a ferro-electric film in the device, and treating the film to improve the stoichiometric composition thereof, characterised in that the treatment comprises doping the film by ion implantation after formation of the film.

In this case, to improve the crystalline characteristics thereof, the film may thereafter be annealed, preferably at above 500°C or by rapid thermal anneal.

Annealing may be performed in an atmosphere containing ozone.

The film may be formed by sputtering in an atmosphere containing ozone.

Alternatively, the sputtering may be in an atmosphere containing lead or a lead compound, for example, PbCl₄, Pb(C₂H₅)₄ and Pb₂O(OH)₂.

The preferred main component of the ferro-electric film is at least on of PbTiO₃, PZT(PbTiO₃/PbZrO₃) and PLZT(La/PbTiO₃/PbZrO₃).

The invention is illustrated, merely by way of example, in the accompanying drawings, in which:-
Figures 1 (a), 1(b) and 1(c) are diagrammatic cross sectional views of a semi-conductor device at successive stages of its manufacture by a method according to this invention;
Figure 2 is a diagrammatic cross sectional view of a sputtering apparatus which may be used in the manufacturing method according to this invention; and
Figure 3 is a similar diagrammatic cross sectional view of another sputtering apparatus which may be used in the method according to the present invention. The manufacturing process according to the invention, will now be described by way of example, as applied to a semi-conductor device including a silicon substrate and an n type channel transistor.

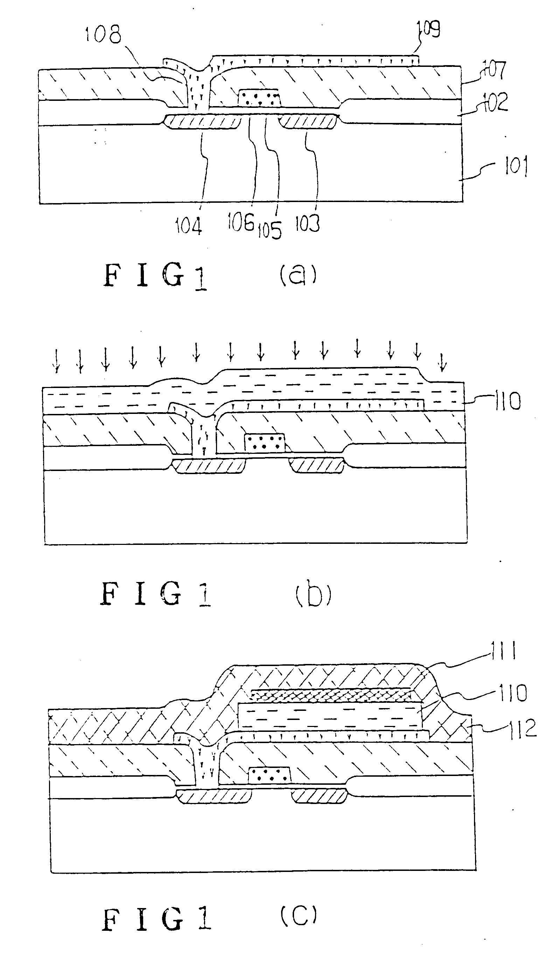

A p type silicon substrate 101 (Figure 1 (a)) with a resistivity of 20 ohm-cm, has n type diffusion layers 103 and 104 formed therein to constitute source and drain of an MOS transistor, by doping 4e¹⁵cm⁻² phosphorous by ion implantation. An insulation film 102, approximately 600 nm (6000 Angstroms) thick is deposited by the LOCOS method to isolate the elements. A gate film 105, approximately 30 nm (300 Angstroms) thick is formed as shown. A gate electrode 106 of polysilicon 400 nm (4000 Angstroms) thick is formed on the gate film 105 between the source and drain layers 103 and 104. An inter-layer insulation film 107 is formed by vapour deposition thereon of SiO₂ to a thickness of 600 nm (6000 Angstroms) and a contact hole 108 is formed through the films 107 and 105 to expose the diffusion layer 104. Thus far, the steps of the manufacturing process are known from the prior art and may be varied in accordance with the particular form of semi-conductor device required.

Next, a bottom electrode 109 for a ferro-electric film is formed upon the film 107 and through the contact hole 108. The film 109 may be of aluminium, deposited by sputtering to a thickness of 1000 nm. Using known photo-lithography methods, the film is formed to a prescribed pattern. This may be done after formation of the ferro-electric film or even after formation of a top electrode upon the ferro-electric film, as described hereinafter. In some cases, to affect the crystalline characteristics of the subsequently deposited ferro-electric film, the film 109 may be of platinum.

Then, a ferro-electric film 110 (Figure 1 (b)) of PbTiO₃ is formed over the film 109 by sputtering to a thickness of, for example, 500 nm (5000 Angstroms). The target for the sputtering is of stoichiometric composition. Then the ferro-electric film 110 is doped by ion implantation at 100 kV, and 5e¹⁵cm⁻² of Pb is implanted. The film 110 is then annealed, for example in a nitrogen atmosphere at approximately 550°C for one hour.

The ferro-electric film 110 (Figure 1 (c)) is then formed to a prescribed shape using photo-lithography, and a top electrode 111 is formed thereon, for example, by sputtering aluminium to a thickness of 500 nm (5000 Angstroms). The top electrode 111 is then shaped and a passivation layer 112 is formed over the whole device, for example by plasma CVD deposition of a SiN film.

The target is of stoichiometric composition, but deviations from stoichiometric composition occur in the sputtered film. These, according to the invention, can be corrected by ion implantation to produce a ferro-electric film of stoichiometric composition. If the ferro-electric film becomes amorphous by such ion implantation, then annealing produces a ferro-electric film with excellent crystalline characteristics. This improves the data retention capability of such devices over that of devices in the prior art, for example from eight months to one and a half years. Also, the read/write capability is improved approximately one hundredfold, from 10⁵ to 10⁷.

Whilst PbTiO₃ is the principal component of the ferro-electric film described, it will be understood that other materials may be used and similar improvements achieved. In particular, PZT(PbTiO₃/PbZrO₃) or PLZT(La/PbTiO₃/PbZrO₃) may be used and remarkable results obtained.

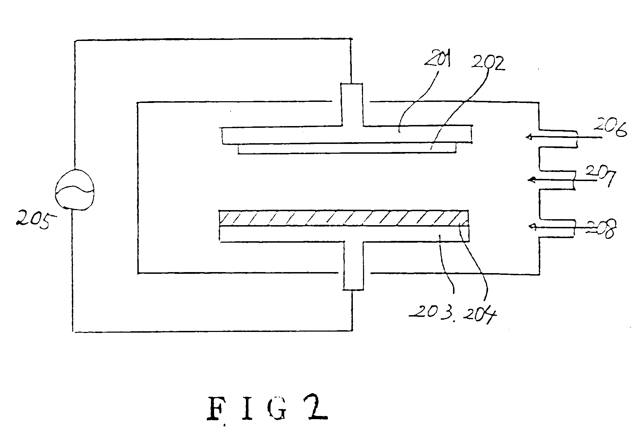

Sputtering of the ferro-electric film may take place in sputtering apparatus such as is shown diagrammatically in Figure 2. A silicon wafer 202 is placed upon an upper electrode 201, and a sintered target 204 is placed upon a bottom electrode 203. The target 204 is, for example, of PZT (65% PbZrO₃ and 35% PbTiO₃). A radio frequency source 205 of electricity is connected across the electrodes 201 and 203 and operates during sputtering. Sputtering gases are introduced through passages 206, 207 and 208. Usually, the gases are argon, oxygen and ozone, though the latter need not always be used. The ratio of such gases may, with advantage, by 80% Ar; 15% O₂; 5% O₃. With the use of ozone, lack of oxygen in the sputtered film does not occur, as the reaction of ozone is very high. This avoids the need for subsequent ion implantation with oxygen. A similar result may be achieved by subsequent annealing in an atmosphere containing ozone after sputtering in an atmosphere of argon and oxygen. Improvement of the crystalline structure of the ferro-electric film is obtained by annealing at above 500°C. Good crystalline characteristics may be achieved by a rapid thermal anneal.

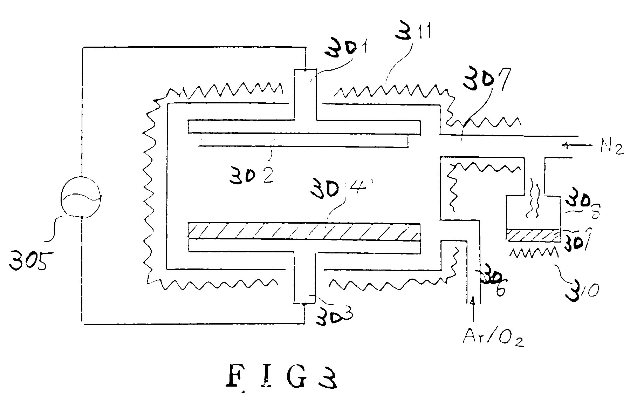

Another sputtering apparatus for use in the invention is shown diagrammatically in Figure 3. In this, a silicon wafer 302 is placed upon a top electrode 301, and a sintered target 304 is placed upon a bottom electrode 303. The target 304 is, for example, PbTiO₃, and a high frequency source 305 of electricity is connected across the electrodes 301 and 303 for operation during sputtering. Sputtering gas is introduced through a gas inlet passage 306 and usually consists of 90% argon and 10% oxygen. An additional sputtering gas is introduced through a gas inlet passage 307, and consists of nitrogen containing the vapour of a lead chemical compound. Such a compound may be Pb(C₂H₅)₄ or PbCl₄, or Pb₂O(OH)₂. Because their boiling points are, respectively, 200°C, 105°C and 145°C, they cannot be introduced in their gaseous state at normal temperature. Accordingly, the chemical compound in solid or liquid form is placed as a mass 309 of, for example, PbCl₄ in a heating chamber 308. A heater 310 is operated to heat the chamber 308 and to evaporate the compound of the mass 309, which is then introduced into the sputtering chamber by a stream of nitrogen acting as a carrier gas through the gas inlet passage 307. The gas ratio is 85% Ar; 10% O₂; 5% N₂ (PbCl₄).

A ferro-electric film of excellent stoichiometric composition is achieved by sputtering when the target is a stoichiometric composition of PbTiO₃, the radio frequency power applied is set at 200 W and the substrate temperature is 500°C. The electrical characteristics of such ferro-electric films are such that the data read/write capability is improved to 10¹⁰.

The invention may be applied to semi-conductor devices other than that shown in Figure 1. For example, a ferro-electric film may be deposited in accordance with the invention in a structure employing bi-polar transistors, or on a CMOS structure, or on a bi-polar/CMOS structure. The substrate may also be of other than silicon, for example gallium arsenide.

By the use of the invention, a semi-conductor device having a ferro-electric film of improved stoichiometric composition and crystalline characteristics may be obtained. To achieve this, a constituent element of the film is doped by ion implantation and thereafter possibly annealed, and sputtering and/or annealing may be performed in an atmosphere containing ozone.

## Claims

1. A method of manufacturing a semi-conductor device, comprising the steps of forming a ferro-electric film (110) in the device, and treating the film (110) to improve the stoichiometric composition thereof, characterised in that the treatment comprises doping the film (110) by ion implantation after formation of the film (110).

2. A method as claimed in claim 1, wherein the doped film (110) is thereafter annealed.

3. A method as claimed in claim 2, wherein the anneal temperature is above 500°C.

4. A method as claimed in claim 2, wherein annealing is performed by rapid thermal anneal.

5. A method as claimed in claim 3 or claim 4, wherein annealing is performed in an atmosphere containing ozone.

6. A method as claimed in claim 1, wherein the film (110) is formed by sputtering using a sputtering atmosphere containing an element for improving the stoichiometric composition of the film.

7. A method as claimed in claim 1, wherein the film (110) is formed by sputtering using a sputtering atmosphere containing ozone.

8. A method as claimed in claim 1, wherein the film (110) is formed by sputtering using a sputtering atmosphere containing lead or a lead compound.

9. A method as claimed in claim 8, wherein the sputtering atmosphere contains at least one of PbCl₄, Pb(C₂H₅)₄ and Pb₂O(OH)₂.

10. A method as claimed in claim 1, wherein the film (110) is formed by sputtering, and is subsequently annealed in an atmosphere containing ozone.

11. A method as claimed in any preceding claim, wherein the main component of the ferro-electric film is at least one of PbTiO₃, PZT(PbTiO₃/PbZrO₃) and PLZT(La/PbTiO₃/PbZrO₃).

## Patentansprüche

1. Verfahren zur Herstellung eines Halbleiter-Bauelements, umfassend die Schritte der Ausbildung eines ferroelektrischen Films (110) in dem Bauelement und der Behandlung des Films (110), um dessen stoichiometrische Zusammensetzung zu verbessern,
gekennzeichnet dadurch, daß
die Behandlung eine Dotierung des Films (110) durch Ionenimplantation nach der Bildung des Films (110) umfaßt.

2. Verfahren nach Anspruch 1, in dem der dotierte Film (110) anschließend getempert wird.

3. Verfahren nach Anspruch 2, in dem die Tempertemperatur über 500°C liegt.

4. Verfahren nach Anspruch 2, in dem das Tempern durch schnelles thermisches Tempern ausgeführt wird.

5. Verfahren nach einem der Ansprüche 3 oder 4, in dem das Tempern in einer Ozon enthaltenden Atmosphäre durchgeführt wird.

6. Verfahren nach Anspruch 1, in dem der Film (110) durch Sputtern unter Verwendung einer ein Element zur Verbesserung der stoichiometrischen Zusammensetzung des Films enthaltenden Sputteratmosphäre gebildet wird.

7. Verfahren nach Anspruch 1, in dem der Film (110) durch Sputtern unter Verwendung einer Ozon enthaltenden Sputteratmosphäre gebildet wird.

8. Verfahren nach Anspruch 1, in dem der Film (110) durch Sputtern unter Verwendung einer eine Blei oder eine Bleiverbindung enthaltenden Sputteratmosphäre gebildet wird.

9. Verfahren nach Anspruch 8, in dem die Sputteratmosphäre PbCl₄ und/oder Pb(C₂H₅)₄ und/oder Pb₂O(OH)₂ enthält.

10. Verfahren nach Anspruch 1, in dem der Film (110) durch Sputtern gebildet wird und anschließend in einer Ozon enthaltenden Atmosphäre getempert wird.

11. Verfahren nach einem der vorangehenden Ansprüche, in dem die Hauptkomponente des ferroelektrischen Films PbTiO₃ und/oder PZT(PbTiO₃/PbZrO₃ und/oder PLZT(La/PbTiO₃/PbZrO₃) enthält.

## Revendications

1. Un procédé de fabrication d'un dispositif à semiconducteur, comprenant les étapes de formation d'une couche ferroélectrique (110), et de traitement de la couche (110) pour améliorer sa composition stoechiométrique, caractérisé en ce que le traitement comprend le dopage de la couche (110) par implantation d'ions après la formation de la couche (110).

2. Un procédé selon la revendication 1, dans lequel la couche dopée (110) est ensuite recuite.

3. Un procédé selon la revendication 2, dans lequel la température de recuit est de plus de 500 °C.

4. Un procédé selon la revendication 2, dans lequel le recuit est réalisé par rapide recuit thermique.

5. Un procédé selon la revendication 3 ou la revendication 4, dans lequel le recuit est réalisé dans une atmosphère contenant de l'ozone.

6. Un procédé selon la revendication 1, dans lequel la couche (110) est formée par pulvérisation en utilisant une atmosphère de pulvérisation contenant un élément pour améliorer la composition stoechiométrique de la couche.

7. Un procédé selon la revendication 1, dans lequel la couche (110) est formée par pulvérisation en utilisant une atmosphère contenant de l'ozone.

8. Un procédé selon la revendication 1, dans lequel la couche (110) est formée par pulvérisation en utilisant une atmosphère contenant du plomb ou un composé du plomb.

9. Un procédé selon la revendication 8, dans lequel l'atmosphère de pulvérisation contient au moins l'un de PbCl₄, Pb(C₂H₅)₄ et Pb₂O(OH)₂.

10. Un procédé selon la revendication 1, dans lequel la couche (110) est formée par pulvérisation, et est ultérieurement recuite dans une atmosphère contenant de l'ozone.

11. Un procédé selon l'une quelconque des revendications précédentes, dans lequel le composant principal de la couche ferroélectrique est au moins l'un de PbTiO₃, PZT(PbTiO₃/PbZrO₃) et PLZT(La/PbTiO₃/PbZrO₃).
